(19) Europäisches Patentamt / European Patent Office / Office européen des brevets

(11) **EP 1 747 571 B1**

(12) **EUROPÄISCHE PATENTSCHRIFT**

(45) Veröffentlichungstag und Bekanntmachung des Hinweises auf die Patenterteilung:
**24.04.2013 Patentblatt 2013/17**

(21) Anmeldenummer: 05714692.0

(22) Anmeldetag: **14.03.2005**

(51) Int Cl.:
*H01J 37/32* *(2006.01)*     *C23C 16/02* *(2006.01)*
*C23C 16/509* *(2006.01)*     *C23C 16/455* *(2006.01)*

(86) Internationale Anmeldenummer:
**PCT/CH2005/000150**

(87) Internationale Veröffentlichungsnummer:
**WO 2005/106917 (10.11.2005 Gazette 2005/45)**

(54) **VERFAHREN ZUR HERSTELLUNG EINES SCHEIBENFÖRMIGEN WERKSTÜCKES AUF DER BASIS EINES DIELEKTRISCHEN SUBSTRATES SOWIE VAKUUMBEHANDLUNGSANLAGE HIERFÜR**

METHOD FOR THE PRODUCTION OF A DISK-SHAPED WORKPIECE BASED ON A DIELECTRIC SUBSTRATE, AND VACUUM PROCESSING SYSTEM THEREFOR

PROCEDE DE PRODUCTION D'UNE PIECE EN FORME DE DISQUE, A BASE D'UN SUBSTRAT DIELECTRIQUE, ET INSTALLATION DE TRAITEMENT SOUS VIDE CORRESPONDANTE

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **30.04.2004 CH 7612004**

(43) Veröffentlichungstag der Anmeldung:
**31.01.2007 Patentblatt 2007/05**

(73) Patentinhaber: **Oerlikon Solar AG, Trübbach
9477 Trübbach (CH)**

(72) Erfinder:
• **BUECHEL, Arthur
FL-9491 Ruggell (LI)**
• **WIELAND, Werner
CH-7208 Malans (CH)**
• **ELLERT, Christoph
A-6800 Feldkirch (AT)**
• **SANSONNENS, Laurent
CH-1426 Concise (CH)**

(74) Vertreter: **Troesch Scheidegger Werner AG
Schwäntenmos 14
8126 Zumikon (CH)**

(56) Entgegenhaltungen:
EP-A- 0 382 632     EP-A- 1 070 767
US-A1- 2003 089 314     US-B1- 6 228 438
US-B1- 6 502 530

**Beschreibung**

Die vorliegende Erfindung geht aus von einem Verfahren zur Herstellung eines scheibenförmigen Werkstückes auf der Basis eines dielektrischen Substrates, welches Herstellungsverfahren die Behandlung in einem Plasmaprozessraum umfasst, der zwischen zwei sich gegenüberliegenden Elektrodenflächen in einem Vakuumrezipienten gebildet ist.

Ein solches Herstellungsverfahren ist aus US 6228438 B1 bekannt, wobei das Prozessgas über die Randzone des Vakuumrezipienten dem Plasmaprozessraum zugeführt wird.

Ferner betrifft EP 0382632 ein Herstellungsverfahren, beim dem vorgängig zur Behandlung im Plasmaprozessraum das Substrat vorbeschichtet wird. Bei der Vorschichtung wird das Substrat mit einer elektrisch leitenden Unterschicht und einer Überschicht beschichtet, wobei die Überschicht auf die Unterschicht aufgebracht wird, um die Plasmaresistenz der Unterschicht zu erhöhen.

Definition

Wir definieren als "Elektrodenfläche" eine Oberfläche, die dem Plasmaprozessraum frei ausgesetzt ist.

Beim genannten Verfahren, von welchem die vorliegende Erfindung ausgeht, wird zwischen den Elektrodenflächen ein elektrisches Hochfrequenzfeld erzeugt und damit in dem mit einem Reaktivgas beschickten Prozessraum eine HochfrequenzPlasmaentladung erstellt. Dabei besteht die eine Elektrodenfläche aus dielektrischem Material und es wird an diese ein Hochfrequenzpotential mit entlang der Fläche vorgegebener, variierender Verteilung angelegt. Die Verteilung des elektrischen Feldes im Plasmaprozessraum wird durch die Potentialverteilung an der dielektrischen Elektrodenfläche eingestellt. Beim Verfahren, von welchem ausgegangen wird, wird mit dem Substrat entweder die dielektrische Elektrodenfläche gebildet oder es wird das Substrat an der metallisch ausgebildeten zweiten Elektrodenfläche angeordnet. Im weiteren wird an der dem Substrat gegenüberliegenden Elektrodenfläche, aus einem Öffnungsmuster, das Reaktivgas in den Prozessraum eingelassen.

In den letzten Jahren ist man mehr und mehr bestrebt, grössere scheibenförmige Werkstücke unter Einbezug reaktiver, hochfrequenzplasmen-unterstützter Verfahren, herzustellen, unter anderem um die Herstellungskosten zu reduzieren. Dabei werden hochfrequenzplasmen-unterstützte, Verfahren ($P_{Hf}ECVD$) zur Substratbeschichtung oder als reaktive hochfrequenzplasmen- unterstützte Ätzverfahren eingesetzt. Das erwähnte Bestreben ist insbesondere erkenntlich bei der Herstellung von Flüssigkristallanzeigen (LCD), von TFT- oder Plasma-Displays, sowie im Gebiete der Fotovoltaik, dabei ganz besonders auf dem Gebiet der Solarzellen-Herstellung.

Bei der Durchführung derartiger Herstellungsverfahren mittels der erwähnten hochfrequenzplasmen-unterstützten, reaktiven Verfahren unter bekanntem Einsatz sich parallel gegenüberliegender, flächiger Metallelektroden, je mit einer den Prozessraum zugewandten, ebenen Elektrodenfläche in einem Vakuumrezipienten und Anlegen des elektrischen Hochfrequenzfeldes für die Plasmaanregung, wurde beobachtet, dass mit grösser werdenden Substraten und/oder höher werdender Anregungsfrequenz $f_{Hf}$ die Dimension des Vakuumrezipienten, in Aufsicht auf das Substrat, nicht mehr von untergeordneter Bedeutung ist. Dies insbesondere mit Blick auf die Wellenlänge des eingesetzten hochfrequenten elektromagnetischen Feldes im Vakuum. Die Verteilung des elektrischen Hochfrequenzfeldes in der Vakuumkammer, betrachtet parallel zu den Elektrodenflächen, wird inhomogen und weicht teilweise von einem Mittelwert entscheidend ab, was zu einer inhomogenen Behandlung des auf einer der Elektrodenflächen positionierten Werkstückes führt: Bei Ätzen ergibt sich eine inhomogene Verteilung der Ätzwirkung, bei Beschichten, beispielsweise der Schichtdicke, der Schichtmaterial-Stöchiometrie etc. Solche signifikante Inhomogenitäten in der Behandlung sind für manche Anwendungen, wie insbesondere bei der Herstellung der erwähnten Flüssigkristalle, TFT- oder Plasmaanzeigen, sowie in der Fotovoltaik, dabei auch ganz besonders bei der Herstellung von Solarzellen, nicht tolerierbar. Die erwähnten Inhomogenitäten sind desto ausgeprägter, je mehr sich die erwähnte Dimension bzw. Ausdehnung des Rezipienten der Wellenlänge des elektrischen Feldes im Rezipienten nähert.

Zur Lösung dieses Problems sind grundsätzlich unterschiedliche Ansätze bekannt:

Aus der US 6 631 692 sowie der US-A-2003/0089314 ist es bekannt, den Plasmaprozessraum zwischen zwei metallischen Elektrodenflächen, die sich gegenüberliegen, zu bilden und dabei eine oder beide der sich gegenüberliegenden metallischen Elektrodenflächen zu formen.

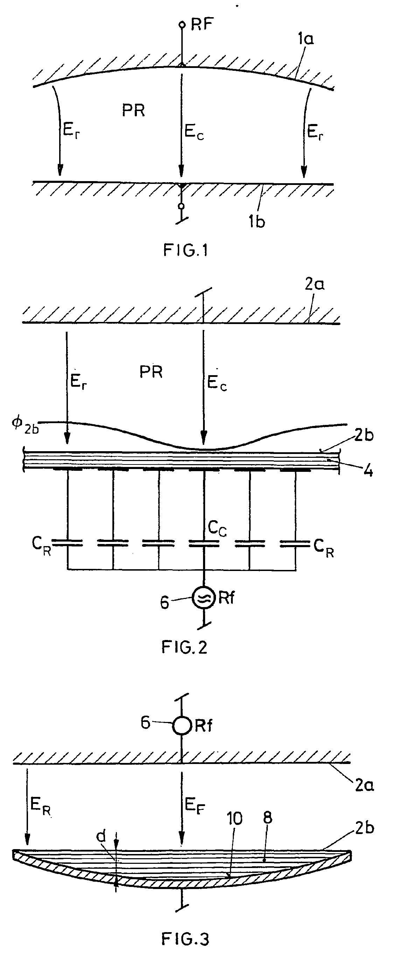

Es wird die metallische Elektrodenfläche, welche dem an der anderen Elektrodenfläche aufliegenden Substrat gegenüber liegt oder die metallische Elektrodenfläche, auf welcher das Substrat aufliegt, oder es werden beide sich gegenüberliegenden metallischen Elektrodenflächen konkav ausgebildet. Dieses vorbekannte Vorgehen ist in Figur 1 schematisch dargestellt, wobei bezeichnen:

1a und 1b:    die sich über dem Prozessraum PR gegenüberliegenden metallischen Elektrodenflächen, zwischen welchen das Hochfrequenzfeld E angelegt wird;

$E_r, E_c$: das entsprechend peripher und zentral entstehende elektrische Feld.

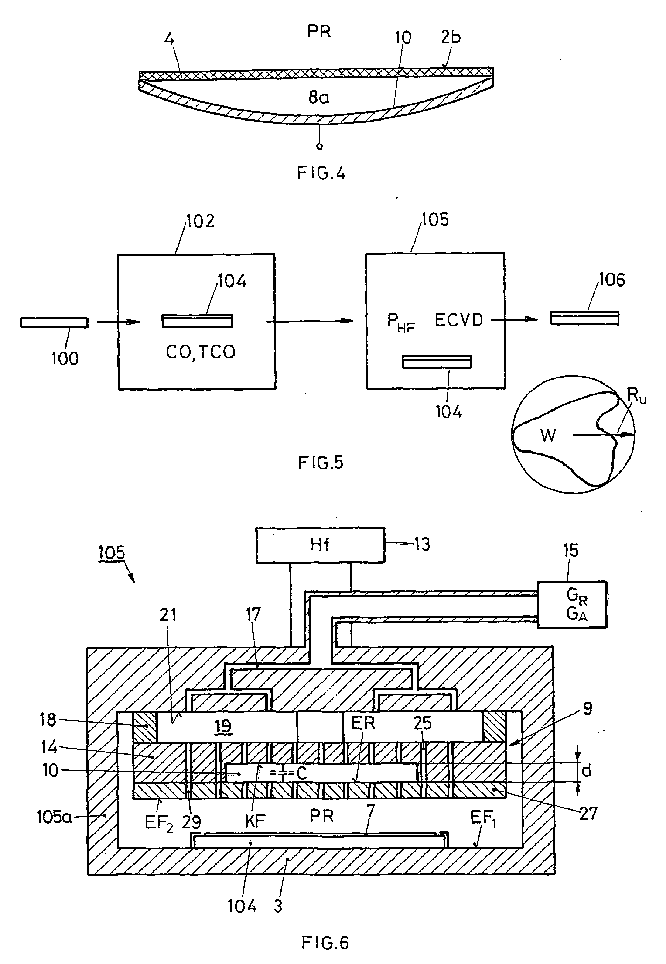

Ein physikalisch grundlegend anderer Ansatz, von welchem auch die vorliegende Erfindung ausgeht, um das obgenannte Problem zu lösen, ist aus der US 6 228 438 derselben Anmelderin wie vorliegende Anmeldung bekannt geworden. Das Prinzip des Vorgehens gemäss der US 6 228 438 soll vorerst anhand von Figur 2 erläutert werden, welche allerdings eine in der erwähnten Schrift nicht offenbarte Realisierungsform darstellt. Diese soll aber der Verständnisgrundlage dienen. Die eine der sich gegenüberliegenden Elektrodenflächen 2a ist beispielsweise und wie dargestellt metallisch. Die zweite Elektrodenfläche 2b besteht hingegen aus dem dielektrischen Material, z.B. einer dielektrischen, flächig ausgebildeten, dünnen Platte 4. Entlang der dielektrischen Elektrodenfläche 2b wird eine Potentialverteilung $\Phi_{2b}$ erstellt, welche trotz konstantem Abstand zwischen den beiden Elektrodenflächen 2a und 2b im Prozessraum PR eine erwünschte lokale Feldverteilung bewirkt, wie dargestellt z.B. im Randbereich ein stärkeres Feld Er als im Zentrumsbereich $E_C$. Dies kann beispielsweise wie in Figur 2 dargestellt realisiert werden, indem ein Hochfrequenzgenerator 6 über kapazitive Elemente $C_R$, $C_C$ unterschiedlich, entsprechend der erwünschten Verteilung, an die dielektrische Platte 4 angekoppelt wird. Bei der in Figur 2 dargestellten, in der erwähnten US 6 228 438 jedoch nicht offenbarten Ausführungsform des in der erwähnten Patentschrift realisierten Prinzips, sind die Kopplungskapazitäten $C_R$ mit grösseren Kapazitätswerten zu wählen als die Zentrumskapazitäten $C_C$. Die Ausbildung der Kapazitäten $C_R$ bzw. $C_C$ wird gemäss der US 6 228 438 so, wie in Figur 3 dargestellt, gelöst. Es wird ein Dielektrikum 8 vorgesehen, welches einerseits die Elektrodenfläche 2b gemäss Figur 2 bildet, welches gleichzeitig, aufgrund seiner lokal variierenden Dicke d bezüglich einer metallischen Kopplungsfläche 10, die gemäss Figur 2 vorgesehenen, lokal variierenden Kapazitäten $C_{R,C}$ bildet. Dabei kann das Dielektrikum 8, wie in Figur 4 dargestellt, durch Festkörperdielektrikum oder durch einen evakuierten oder gasgefüllten Hohlraum 8a zwischen metallischer Kopplungsfläche 10 und einer die Elektrodenfläche 2b bildenden, dielektrischen Platte 4, gebildet sein. Wesentlich ist, dass sich im letzterwähnten Hohlraum 8a keine Plasmaentladung bildet.

Die vorliegende Erfindung geht von dem anhand der Figuren 2 bis 4 grundsätzlich erläuterten, vorbekannten Vorgehen gemäss der US 6 228 438 aus. Bei diesem Vorgehen stellt sich nun die Frage, wo ein zu behandelndes Substrat im Prozessraum $P_R$ zu positionieren ist, an der dielektrischen Elektrodenfläche 2b oder an der metallischen Elektrodenfläche 2a. In der erwähnten US 6 228 438 wird gelehrt, dielektrische Substrate auf der Elektrodenfläche 2b oder der Elektrodenfläche 2a abzulegen, hingegen (Kol. 5, Z. 35 ff.) Substrate mit elektrisch leitender Oberfläche an der metallischen Elektrodenfläche 2a.

Im weiteren ist es aus der erwähnten Schrift bekannt, Reaktivgas in den Prozessraum einzulassen, und zwar aus einem Öffnungsmuster verteilt an der dem zu behandelnden Substrat gegenüberliegenden Elektrodenfläche. Wird mithin ein dielektrisches Substrat gemäss Figur 3 oder 4 an der Elektrodenfläche 2b abgelegt, so ist das Öffnungsmuster mit der Gaszuführung auf der Seite der metallischen Elektrodenfläche 2a vorzusehen. Wird das Substrat an der metallischen Elektrodenflächen 2a angeordnet, so ist das Öffnungsmuster für das Reaktivgas auf Seite der dielektrischen Elektrodenfläche 2b vorzusehen. Es kann dann, wie sich aus Figur 4 ohne weiteres ergibt, der Hohlraum 8a als Ausgleichskammer eingesetzt werden und das Reaktivgas erst durch die metallische Kopplungsanordnung mit Kopplungsfläche 10 in die Ausgleichskammer 8a und durch das in der dielektrischen Platte 4 vorgesehene Öffnungsmuster in den Prozessraum PR eingelassen werden. Allerdings ist es durchaus möglich den Hohlraum 8a mit einem dielektrischen Feststoff zu füllen, sei dies mit dem die dielektrische Elektrooberfläche 2b bildenden Material oder einem oder mehreren mindestens zum Teil davon verschiedenen und das Öffnungsmuster, durch diesen Feststoff hindurch, über verteilte Leitungen mit dem Reaktivgas zu versorgen.

Grundsätzlich ist davon auszugehen, dass die Kombination des Öffnungsmusters zum Einlass des Reaktivgases in den Prozessraum und des Dielektrikums 8 bzw. 8a gemäss den Figuren 3 bzw. 4 an einer einzigen Elektrodenanordnung wesentlich aufwändiger ist als Vorsehen des Öffnungsmusters an der Elektrodenfläche 2a gemäss Figur 3 und Ablegen des zu behandelnden Substrates auf der dielektrischen Elektrodenfläche 2b bzw. gar Ausbilden der dielektrischen Elektrodenfläche 2b durch ein dielektrisches Substrat selber.

Es erscheint nämlich vorteilhaft, die Gaseinlassvorkehrungen mit dem Öffnungsmuster und die Beeinflussungsmassnahmen für das elektrische Feld funktionell zu trennen, d.h. wenn immer möglich das zu behandelnde Substrat an der dielektrischen Elektrodenfläche 2b abzulegen oder die dielektrische Elektrodenfläche 2b mindestens teilweise durch das Substrat zu bilden und die Gaseinlassverhältnisse durch das Öffnungsmuster an der metallischen Elektrodenfläche 2a zu gestalten.

Es ist Aufgabe der vorliegenden Erfindung, ein Verfahren zur Herstellung eines scheibenförmigen Werkstückes auf der Basis eines dielektrischen Substrates vorzuschlagen, mittels welchem mit einer speziellen Schicht versehene Werkstücke unter Verwendung des grundsätzlich aus der US 6 228 438 vorbekannten Verfahrens herstellbar sind. Die derart hergestellten scheibenförmigen Werkstücke sollen dabei insbesondere für den Einsatz als Solarzellen geeignet sein. Dies wird dadurch erreicht, dass das dielektrische Substrat zuerst, also vor der Behandlung im vorerwähnten Hochfrequenz-Plasmaprozessraum, mindestens abschnittweise, mit einem Schichtmaterial beschichtet wird, für dessen spezifischen Widerstand p gilt:

$$10^{-5} \; \Omega \, \text{cm} \leq \rho \leq 10^{-1} \; \Omega \, \text{cm}$$

und woran für den Flächenwiderstand $R_S$ der Schicht gilt:

$$0 \; < \; R_S \; \leq \; 10^4 \; \Omega_{\square}$$

dann das beschichtete Substrat an der metallischen Elektrodenfläche positioniert wird und im Plasmaprozessraum reaktiv plasmaunterstützt geätzt oder beschichtet wird.

Obwohl, wie erwähnt wurde, beim vorbekannten Vorgehen eine Funktionstrennung von Gaseinlassmassnahmen und Feldbeeinflussungsmassnahmen und ihre Zuordnung an jeweilige Elektrodenflächen aus Konstruktionsgründen eher anzustreben war, hat sich nun gezeigt, dass die Kombination von Vorbeschichten des dielektrischen Substrates mit der erwähnten Schicht und dem grundsätzlich vorbekannten $P_{Hf}$ECVD-Verfahren nur dann Erfolg zeitigt, wenn, nach der Beschichtung, das Substrat im Plasmaprozessraum an der metallischen Elektrodenfläche abgelegt wird und die Feldbeeinflussungsmassnahmen sowie der Reaktivgaseinlass durch das erwähnte Öffnungsmuster kombiniert an bzw. im Bereich der dielektischen Elektrodenfläche realisiert werden.

Es wurde nämlich erkannt, dass nach erfolgter Beschichtung des dielektrischen Substrates mit der spezifischen Schicht nur die erwähnte Substratpositionierung zum Erfolg führt und damit die vorerst als eher nachteilig zu betrachtende Funktionskombination an der dielektrischen Elektrodenfläche realisiert werden muss.

Mit dem vorgeschlagenen Vorgehen wird zudem vorteilhafterweise eine hohe Flexibilität bezüglich der Art von Hf-Plasma-Behandlung erreicht. Unabhängig davon, ob nämlich das vorgängig mit der spezifizierten Schicht beschichtete dielektrische Substrat geätzt oder beschichtet wird, weiter auch unabhängig davon, ob es durch einen $P_{Hf}$ECVD-Prozess dielektrisch bis hin zu elektrisch hoch leitend beschichtet wird: Der jeweilige Behandlungsprozess ist davon unbeeinflusst, was die Wirkung der Feldverteilungsmassnahmen im Plasmaprozessraum anbelangt bzw. der Gaseinlassmassnahmen.

Wie bereits vorgängig erwähnt, wird im Rahmen der vorliegenden Erfindung das dielektrische Substrat erst beschichtet mit einem Material, dessen spezifischer elektrischer Widerstand ρ wesentlich höher ist als an herkömmlicherweise als "metallisch" oder "elektrisch leitend" bezeichneten Materialien. So liegen die spezifischen Widerstände herkömmlicher Leitermaterialien wie von Gold, Silber, Kupfer, Aluminium im Bereich von 1,7 x $10^{-6}$ Ωcm bis 2,7 7 x $10^{-6}$ Ωcm.

Definition

Der Flächenwiderstand $R_S$ ergibt sich aus dem Quotienten des spezifischen Widerstandes ρ und der Schichtdicke. Er hat die Dimension Ω, mit dem Zeichen $\square$ indiziert.

Der Flächenwiderstand $R_S$ einer betrachteten Schicht ist mithin sowohl material- wie auch schichtdicken-abhängig. Gemäss vorliegender Erfindung wurde erkannt, dass die Wahl des Verfahrens nicht nur davon abhängt, ob die Oberfläche eines dielektrischen Substrates mit einem elektrisch mehr leitenden oder elektrisch weniger leitenden Material vorbeschichtet ist, sondern entscheidend auch davon, wie bei den genannten Materialien der Flächenwiderstand $R_S$ der Schicht ist.

Erfindungsgemäss wird die Verteilung des Hochfrequenzpotentials an der dielektrischen Elektrodenfläche und der Einlass von Reaktivgas in den Prozessraum dadurch realisiert, dass die dielektrische Elektrodenfläche durch eine dem Prozessraum zugewandte Oberfläche einer dielektrischen Plattenanordnung gebildet wird, deren Rückseite mit einer metallischen Kopplungsfläche eine Kammer bildet, wobei der Abstand der Rückseite von der Kopplungsfläche, entlang diesen Flächen, variiert und dass weiter das Reaktivgas in die Kammer, dann durch das in der Plattenanordnung vorgesehene Öffnungsmuster in den Prozessraum eingelassen wird. An der Kopplungsfläche und die andere Elektrodenfläche, die elektrisch leitend ist, wird ein Hochfrequenzsignal für die Plasmaerregung angelegt.

Durch den variierenden Abstand zwischen metallischer Kopplungsfläche und Rückseite der dielektrischen Plattenanordnung wird die Kapazitätsverteilung gemäss Figur 2 realisiert und der Kammerraum, zwischen dieser Rückseite und der metallischen Kopplungselektrodenfläche, wird gleichzeitig als Verteilkammer für das Reaktivgas ausgenützt, welches durch das Öffnungsmuster in der dielektrischen Plattenanordnung in den Prozessraum strömt.

Wenn wir im Rahmen der vorliegenden Anmeldung von "Reaktivgas" sprechen, so ist darunter auch eine Gasmischung mit einem oder mehreren Reaktivgasen zu verstehen.

Die erwähnte dielektrische Plattenanordnung bildet, mit Blick auf Figur 2, mit ihrem durch ihre Dicke mitbestimmten Kapazitätswert, Teil der in Figur 2 dargestellten Kopplungskapazitäten $C_R$ bzw. $C_C$. Damit kann, in einer Ausführungsform, die dielektrische Plattenanordnung mit einer vorgegebenen, variierenden Dickenverteilung eingesetzt werden. In einer anderen Ausführungsform wird jedoch die dielektrische Plattenanordnung mit einer wenigstens genähert konstanten Dicke eingesetzt. In einer noch weiteren Ausführungsform nähert sich die Potentialverteilung an der dielektrischen Elektrodenfläche vom Zentrum gegen ihre Peripherie hin zunehmend dem Potential an der Kopplungsfläche. Dies wird, bei der Realisation der oben erwähnten Kammer zwischen metallischer Kopplungsfläche und Rückseite der dielektrischen Plattenanordnung, z.B. dadurch erreicht, dass der diesbezüglich Abstand im Peripheriebereich geringer gewählt wird als im Zentrumsbereich und/oder dadurch, dass die Dicke der dielektrischen Plattenanordnung im Peripheriebereich geringer ausgelegt wird als im Zentrumsbereich.

Der Kapazitätswert wird im Zentrumsbereich kleiner gewählt als im Peripheriebereich.

Bei Ausbildung dieser Kapazität über eine Kammer (8a von Fig. 4) wird dies z.B. realisiert, indem

a) die metallische Kopplungsfläche im Wesentlichen plan ausgebildet wird, die dielektrische Plattenanordnung, im Wesentlichen konstanter Dicke, vom Prozessraum her betrachtet, konvex;

b) die dielektrische Plattenanordnung, mit im Wesentlichen konstanter Dicke plan ausgebildet wird, die Kopplungsfläche, vom Prozessraum her betrachtet, konkav;

c) die Kopplungsfläche konkav ausgebildet wird, die Rückseite der dielektrischen Plattenanordnung ebenfalls, und, vom Prozessraum her betrachtet, die dielektrische Elektrodenfläche konkav;

d) die Kopplungsfläche im Wesentlichen plan ausgebildet wird, die dielektrische Plattenanordnung mit planer Rückseite parallel zur Kopplungsfläche und mit, vom Prozessraum her betrachtet, konvexer Elektrodenfläche;

e) die Kopplungsfläche plan ausgebildet wird, ebenso die Elektrodenfläche, die Plattenrückseite hingegen, betrachtet vom Prozessraum her, konvex.

Wird keine Kammer vorgesehen, so können z.B. die Kopplungsfläche und die Elektrodenfläche parallel sein, die Dielektrizitätskonstante des dazwischen liegenden Festköper-Dielektrikums gegen die Peripherie hin zunehmen.

Es ist ersichtlich, dass für die Optimierung einerseits der Feldverteilung im Prozessraum, anderseits der Gaseinlassrichtungsverteilung in den Prozessraum hohe Flexibilität besteht. Es können, obwohl die Feldverteilungsmassnahmen und die Gasverteilungsmassnahmen an derselben Elektrodenanordnung realisiert werden, beide Grössen je optimiert werden. Die beispielsweise erwähnten Vorgehensweisen können durchaus gemischt und kombiniert eingesetzt werden. Es kann beispielsweise die Kopplungsfläche im Wesentlichen plan ausgebildet werden, die dielektrische Plattenanordnung mit variierender Dicke mit einer vom Prozessraum her betrachtet konkaven Rückseite und konvexer Elektrodenfläche. Im Weiteren ist es dem Fachmann durchaus klar, dass als eine weitere Auslegungsgrösse für die in Figur 2 erläuterte Kapazitätsverteilung auch die Dielektrizitätskonstante der dielektrischen Plattenanordnung ist, bzw. deren Verteilung eingesetzt werden kann. Durch Wahl unterschiedlicher Materialien entlang der dielektrischen Plattenanordnung kann die erwähnte Kapazitätsverteilung und damit die Potentialverteilung an der dielektrischen Elektrodenfläche zusätzlich oder alternativ zur Abstands- bzw. Dickenvariation beeinflusst werden.

Dabei kann insbesondere die dielektrische Elektrodenfläche plan und parallel zur anderen, den Prozessraum definierenden Elektrode gewählt werden, um damit einen Plasmaprozessraum konstanter Tiefe senkrecht zu den Elektrodenflächen zu realisieren. Diese bevorzugte Ausführungsform ergibt sich z.B. dadurch, dass die metallische Kopplungsfläche, vom Prozessraum her betrachtet, konkav ausgebildet wird, die Rückseite der Plattenanordnung plan oder dadurch, dass die Rückseite der dielektrischen Plattenanordnung, vom Prozessraum her betrachtet, konvex ausgebildet wird, die Kopplungsfläche plan, oder dadurch, dass entlang der dielektrischen Plattenanordnung oder Elektrodenfläche Materialien unterschiedlicher Dielektrizitätskonstanten eingesetzt werden, bei planer metallischer Kopplungsfläche und dazu paralleler planer Plattenrückseite, im Peripheriebereich Materialien höherer Dielektrizitätskonstanten eingesetzt werden als im Zentrumsbereich.

Berücksichtig man, dass mit dem erfindungsgemässen Verfahren insbesondere grosser Substrate mit einer Ausdehnung ihres Umkreises von mindestens 0.5 m erst erfindungsgemäss beschichtet und dann der Hf-Plasma-Behandlung zu unterziehen sind, so ist ersichtlich, dass die Bereitstellung der obgenannte dielektrischen Plattenanordnung mit Öffnungsmuster und Kammerbildung aufwändig ist.

In der erfindungsgemäße Vakuumbehandlungsanlage wird deshalb die dielektrische Plattenanordnung durch keramische Kacheln gebildet. Diese Kacheln sind zentral bezüglich der metallischen Kopplungsfläche auf Abstand positioniert montiert Damit ergibt sich, dass sich die dielektrische Elektrodenfläche aufgrund thermischer Verformungen der Kacheln nicht verformt, was auf die Feldverteilung und ggf. die Reaktivgaszuführung in den Prozessraum negativ Einfluss nähme. Im Weiteren können die Kacheln aus unterschiedlichen Materialien mit unterschiedlichen Dielektrizitätskonstanten, mit unterschiedlichen Dicken und Dickenprofilen flexibel zur gezielten Bildung erwünschter Platteneigenschaften eingesetzt werden, können durch gegenseitige Überlappung und mehrschichtige Anordnung zur Ausformung konkaver bzw. konvexer Elektrodenflächen oder Anordnungsrückseite eingesetzt werden.

An dieser Stelle sei nochmals betont, dass es - sofern eine Kammer gebildet wird - wesentlich ist zu verhindern, dass sich in dieser zwischen metallischer Kopplungsfläche und Rückseite der dielektrischen Plattenanordnung gebildeten Kammer parasitäre Plasmaentladungen einstellen, welche die Wirkung dieser Kammer als flächig verteilte Kopplungskapazität zunichte machen würden. Dies wird, wie dem Fachmann bekannt, durch Bemessung der Abstandsverhältnisse zwischen metallischer Kopplungsfläche und Rückseite der dielektrischen Plattenanordnung sichergestellt, jedenfalls geringer als der beim jeweiligen Prozess gültige Dunkelraumabstand.

In einer weiteren Ausführungsform variiert der Abstand der Plattenanordnungsrückseite von der metallischen Kopplungsfläche in einer, vorzugsweise in mehreren Stufen und/oder es variiert die Dicke der Platte in einer, vorzugsweise in mehreren Stufen. Diese Ausbildungsform wird z.B. realisiert durch Einsatz sich überlappender Kacheln zum Aufbau der dielektrischen Plattenanordnung bzw. beim Einsatz mehrerer Kachelschichten mit örtlich variierender Schichtzahl.

In einer weiteren Ausführungsform wird der Abstand der Plattenanordnungsrückseite von der metallischen Kopplungsfläche stetig variiert und/oder die Dicke der Plattenanordnung stetig variiert. Diese Ausbildung wird eingesetzt, wenn eine im Wesentlichen plane dielektrische Plattenanordnung eingesetzt wird, mit konstanter Dicke und die metallische Kopplungsfläche, betrachtet vom Prozessraum her, konkav eingeformt wird.

In einer Ausführungsform des erfindungsgemässen Herstellungsverfahrens, insbesondere für Solarzellen, wird das dielektrische Substrat, vor der Behandlung im Plasmaprozessraum, mit einem elektrisch leitenden Oxid beschichtet, dabei bevorzugt einem elektrisch leitenden und transparenten Oxid: Diese vor der Behandlung erfolgende Beschichtung kann beispielsweise durch reaktives Magnetronsputtern erfolgen. Weiter bevorzugt wird dabei das dielektrische Substrat mit mindestens einem der folgenden Materialien: $ZnO$, $InO_2$, $SnO_2$, dabei zusätzlich dotiert oder undotiert, beschichtet, mit einer Dicke D, für die gilt:

$$10 \text{ nm} \leq D \leq 5 \text{ } \mu m.$$

Die Beschichtung der erwähnten Materialien innerhalb des angegebenen Dickenbereiches erfüllt die spezifischen, oben angegebenen Schichteigenschaften bezüglich spezifischen Widerstand p und Flächenwiderstand $R_S$.

Das derart beschichtete Substrat wird anschliessend durch die Behandlung im Plasmaprozessraum reaktiv geätzt und/oder beschichtet. Dabei wird bevorzugt als Reaktivgas mindestens eines der folgenden Gase eingesetzt: $NH_3$, N2, $SF_6$, $CF_4$, $Cl_2$, $O_2$, $F_2$, $CH_4$, Silan, Disilan, $H_2$, Phosphin, Diboran, Trimetylbor, $NF_3$.

Es werden beispielsweise folgende Schichten abgelegt:

| Schicht: | Eingesetztes Reaktivgas: |
|---|---|
| amorphes Silizium (a-Si) | $SiH_4$, $H_2$ |
| n-dotiertes a-Si | $SiH_4$, $H_2$, $PH_3$ |
| p-dotiertes a-Si | $SiH_4$, $H_2$, TMB, $CH_4$ |
| microkristallines Si | $SiH_4$, $H_2$ |

Für reaktives Ätzen wi-rd dabei, z.B. $SF_6$ gemischt mit $O_2$ als Reaktivgas eingesetzt.

Im Weiteren wird das elektrische Hochfrequenzfeld bevorzugt mit einer Frequenz $f_{Hf}$ angeregt, für die gilt:

$$10 \text{ MHz} \leq f_{Hf} \leq 500 \text{ MHz}$$

bzw.

$$13 \text{ MHz} \leq f_{Hf} \leq 70 \text{ MHz}.$$

Die hergestellten Werkstücke haben weiter bevorzugt einen Umkreisradius, der mindestens 0.5 m beträgt.

Die zur Durchführung des erfindungsgemässen Verfahrens eingesetzte erfindungsgemäße Vakuumbehandlungsanlage hat

- einen Vakuumrezipienten, darin
- eine erste plane, metallische Elektrodenfläche,

● eine zweite, der ersten zugewandte dielektrische Elektrodenfläche, welche die eine Oberfläche einer dielektrischen Plattenanordnung bildet,

● eine der Rückseite der dielektrischen Plattenanordnung zugewandte, metallische Kopplungsfläche,

● elektrische Anschlüsse je an die Kopplungs- und die erste Elektrodenfläche,

● ein Gasleitungssystem, das durch die Kopplungsfläche und ein verteiltes Muster von Öffnungen durch die Plattenanordnung ausmündet und

zeichnet sich dabei dadurch aus, dass die Plattenanordnung durch mehrere keramische Kacheln gebildet ist, die zentral bezüglich der Kopplungsfläche auf abstand positioniert montiert sind. Ausführungsformen der erfindungsgemäss eingesetzten Vakuumbehandlungsanlage eröffnen sich dem Fachmann weiter aus den Ansprüchen sowie aus der nachfolgenden beispielsweisen Beschreibung der Erfindung.

Die Erfindung wird nämlich anschliessend anhand von Ausführungsbeispielen und Figuren weiter beschrieben. Es zeigen:

| | |
|---|---|
| Fig. 5 | schematisch, anhand eines FunktionsblockDiagrammes den Ablauf des erfindungsgemässen Herstellungsverfahrens; |
| Fig. 6 | in Querschnittsdarstellung, schematisch und vereinfacht, eine Ausführungsform einer eingesetzten Vakuumbehandlungsanlage; |
| Fig. 7 | weiter vereinfacht, die Aufsicht auf eine an der Anlage gemäss Fig. 6 eingesetzte Kopplungsfläche; |
| Fig. 8 | als Referenzbeispiel, über den Diagonalausdehnungen an einem rechteckförmigen dielektrischen Substrat, die resultierende Schichtdickenverteilung bei $P_{Hf}$ECVD-Beschichtung unter Einsatz herkömmlicher, sich gegenüberliegender, planer, metallischer Elektroden; |
| Fig. 9 | als Referenzbeispiel, in Darstellung analog zu Fig. 8, das Verteilungsresultat an einem dielektrischen Substrat, positioniert direkt über einer konkav eingeformten, metallischen Elektrodenfläche; |
| Fig. 10 | weiter als Referenzbeispiel, in analoger Darstellung zu den Fig. 8 und 9, das Resultat bei Vorgehen gemäss Fig. 9, jedoch an einem erfindungsgemäss mit einer $InO_2$-Schicht beschichteten Substrat; |
| Fig. 11 | das nach dem erfindungsgemässen Verfahren sich ergebende Schichtdicken-Verteilungprofil; |
| Fig. 12 | vereinfacht und schematisch, eine eingesetzte Anlage in einer weiteren bevorzugten Ausführungsform; |
| Fig. 13 | einen Ausschnitt aus dem in Fig. 12 mit "A" bezeichneten Bereich, zur Erläuterung einer weiteren bevorzugten Ausführungsform; |
| Fig. 14 | in einer Darstellung analog zu derjenigen von Fig. 12, eine weitere Ausführungsform der eingesetzten Anlage; |
| Fig. 15 (a) bis (f) | schematisch, eine Auswahl von Möglichkeiten, durch entsprechende Formung der dielektrischen Plattenanordnung und der metallischen Kopplungsfläche, im Prozessraum peripher das elektrische Feld zu erhöhen; |
| Fig. 16 | detailliert, eine bevorzugte Montage einer Keramikkachel zur Bildung der dielektrischen Plattenanordnung an der metallischen Kopplungsfläche eine erfindungsgemäßen Vakuumbehandlungsanlage, und |
| Fig. 17 | die Realisation der beispielsweise in Fig. 15 dargelegten Möglichkeiten durch Aufbau der dielektrischen Platte mittels keramischer Kacheln. |

In Figur 5 ist anhand eines vereinfachten Blockdiagrammes der Ablauf des erfindungsgemässen Verfahrens dargestellt. Ein dielektrisches Substrat 100 wird an einer ersten Vakuumbeschichtungsstation 102, beispielsweise einer Station zum reaktiven Magnetronsputtern, mindestens teilweise beschichtet mit einer Schicht, deren Material einen spezifischen Widerstand $\rho$ hat, für den gilt

$$10^{-5}\ \Omega\ cm \leq \rho \leq 10^{-1}\ \Omega\ cm$$

und zwar so, dass der resultierende Flächenwiderstand $R_S$ der Schicht im folgenden Bereiche liegt:

$$0\ <\ R_S\ \leq\ 10^{-4}\ \Omega_\square.$$

Die untere Grenze kann gegen 0 gehen, weil der Flächenwiderstand $R_S$ von der Dicke der abgelegten Schicht abhängt. Diese Dicke $D_S$ der Schicht wird bevorzugterweise wie folgt gewählt:

$$10 \; nm \le D_S \le 5 \; \mu m,$$

insbesondere, wenn das abgelegte Schichtmaterial wie weitaus bevorzugt ein elektrisch leitendes Oxid (CO), dabei ggf. ein transparentes, elektrisch leitendes Oxid (TCO) ist. Hierzu werden mindestens eines der folgenden Materialien $InO_2$, $ZnO$, $SnO_2$ auf das dielektrische Substrat 100 abgelegt, dotiert oder nicht dotiert. Darnach wird das beschichtete dielektrische Substrat 104 einem reaktiven Hf-Plasma-Behandlungsschritt an der Station 105, nämlich einem $P_{Hf}$ECVD-Behandlungsschritt, oder einem reaktiven Hf-Plasma unterstützten Ätzschritt zugeführt. Es resultiert ein Werkstück 106, das insbesondere geeignet ist für den Einsatz als Solarzellen.

Das Substrat 100 und damit auch das erfindungsgemäss resultierende Substrat 106 hat dabei vorzugsweise einen Umkreisradius $R_U$ von mindestens 0,25 m, entsprechend einem Umkreisdurchmesser von 0,5 m, wie dies in Figur 5 an einem beliebig geformten Werkstück W dargestellt ist.

In Figur 6 ist, in Querschnittsdarstellung und vereinfacht, eine erste Ausführungsförm einer eingesetzten Station bzw. Anlage 105 gemäss Fig. 5 dargestellt. Ein metallischer Vakuumrezipient 105a hat eine plane Grundfläche 3, welche, dem Innenraum zugewandt, eine erste Elektrodenfläche $EF_1$ bildet. Darauf liegt das Substrat 104 aus dielektrischem Material, beschichtet -7- mit dem erwähnten Schichtmaterial.

Dem mit der Schicht 7 versehenen Substrat 104 bzw. der ersten Elektrodenfläche $EF_1$ gegenüberliegend ist eine Elektrodenanordnung 9 montiert. Sie bildet die zweite Elektrodenfläche $EF_2$.

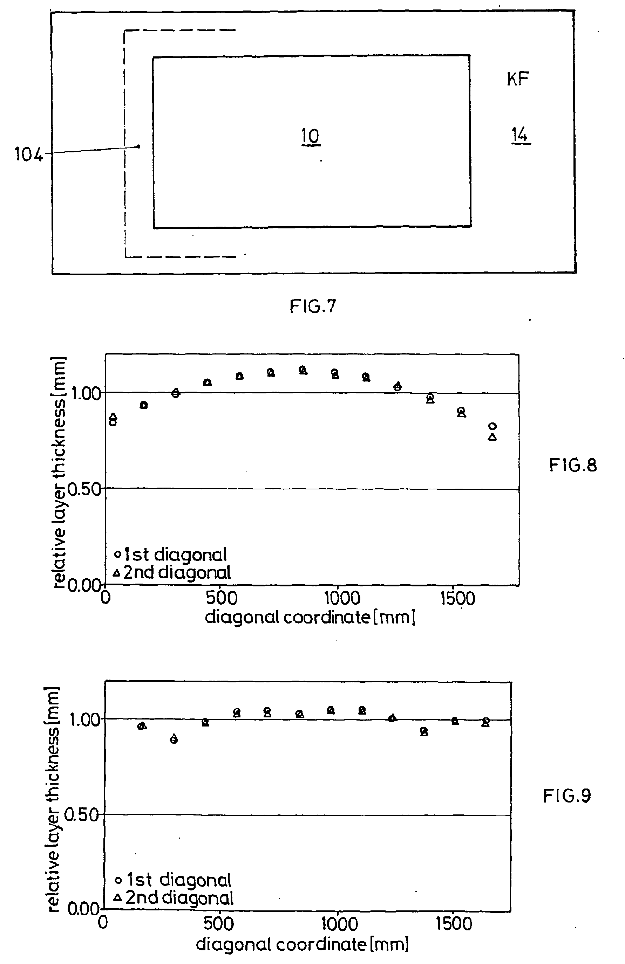

Die zweite Elektrodenfläche $EF_2$, im dargestellten Beispiel plan der Elektrodenfläche $EF_1$ gegenüberliegend, ist gebildet durch die Oberfläche einer dielektrischen Plattenanordnung 27. Die Rückseite ER der dielektrischen Plattenanordnung 27 bildet gemeinsam mit einer metallischen Kopplungsfläche KF eine Kammer 10. Dabei ist am dargestellten Beispiel die Kopplungsfläche KF als Einformung 10 ausgebildet, die, betrachtet vom Prozessraum PR her, konkav in eine Metallplatte 14 eingearbeitet ist. Die am Beispiel dargestellte Einformung 10 ist, wie schematisch in Fig. 7 dargestellt, rechteckförmig und bildet eine Abstandsverteilung des Abstands d zwischen Kopplungsfläche KF und Rückseite ER der dielektrischen Plattenanordnung 27, die sprungartig von 0 auf den konstanten Abstand in der Einnehmung 10 springt. In Fig. 7 ist gestrichelt das Substrat 104 eingetragen. Über die Metallplatte 14 ist ein Hochfrequenzgenerator 13 mit der Kopplungsfläche KF verbunden, der weiter mit der üblicherweise auf Bezugspotential gelegten Elektrodenfläche $EF_1$ verbunden ist.

Von einem Gasvorrat 15 wird Reaktivgas $G_R$ oder ein Reaktivgasgemisch und gegebenenfalls ein Arbeitsgas $G_A$, wie z.B. Argon, über ein Verteilleitungssystem 17 in eine Vorkammer 19 rückseitig der Platte 14 eingespiesen. Die Vorkammer 19 wird einerseits durch eine die Platte 14 bezüglich dem Rezipienten 105a isolierende Halterung 18 umrandet, anderseits von der Rückseite der Platte 14 und die der metallischen Elektrodenfläche $EF_1$ zugewandte Stirnwand 21 des Rezipienten 105a gebildet. Die Platte 14 hat ein Muster durch sie durchgeführter Gasleitungsbohrungen 25.

Die Gasleitungsöffnungen 25 in der Platte 14 setzen sich, vorzugsweise fluchtend, in Öffnungen 29 durch die dielektrische Plattenanordnung 27 hindurch fort. Die Plattenanordnung 27 besteht in diesem Beispiel aus einer Keramik, z.B. aus $Al_2O_3$.

Mittels des Generators 13, über die Kopplungsfläche KF, wird im Prozessraum PR eine Hochfrequenzplasmaentladung Hf erstellt.

Dabei wird von der metallischen Kopplungsfläche KF über die in Fig. 6 gestrichelt eingetragene, flächig verteilte Kapazität C die dielektrische Elektrodenfläche $EF_2$ eine wie bereits erläutert wurde gezielt vorgegebene Potentialverteilung realisiert.

Die Anregungsfrequenz $f_{Hf}$ wird wie folgt gewählt:

$$10 \; MHz \le \; f_{Hf} \le 500 MHz$$

dabei insbesondere

$$13 \; MHz \le f_{Hf} \le 70 \; MHz.$$

Der Umkreisdurchmesser des Substrates 104 ist mindestens 0,5 m und kann durchaus bis zu 5m und mehr betragen.

Der Abstand d springt bei der Ausführung gemäss Fig. 6 von 0 auf 1 mm.

Wie bereits erwähnt wurde, wird an noch zu erläuternden Ausbildungsvarianten der Anlage die Kammer 10 nicht mit einem von 0 auf einen konstanten Wert springenden Abstand d ausgelegt, sondern es wird optimiert der erwähnte Abstand, welcher ja die für die Feldverteilung massgebliche Kapazitätsverteilung massgeblich mitbestimmt, mit einer bestimmten Verteilung ausgelegt. Dieser Abstand d wird frequenzabhängig zwischen 0,05 mm und 50 mm gewählt, so dass in der Kammer 10 kein Plasma entstehen kann.

Mittels des Generators 13 wird bevorzugterweise pro Substratfläche eine Leistung von 10 bis 5000W/m$^2$ eingespiesen.

Für P$_{Hf}$ECVD-Beschichten des Substrates 104 wird, als Reaktivgas, bevorzugterweise mindestens eines der folgenden eingesetzt: $NH_3$, $N_2$, $SF_6$, $CF_4$, $Cl_2,O_2$, $F_2$, $CH_4$, Silan, $H_2$, Phosphin, Diboran, Trimethylbor.

Der gesamte Gasfluss durch das System 15, 17, schliesslich aus den Öffnungen 29 beträgt z.B. pro m$^2$ Substratfläche, zwischen 0,05 und 10slm/m$^2$.

Die oben angegebenen Grössen gelten insbesondere für reaktives hochfrequenzplasma-unterstütztes Beschichten.

Für die nachfolgenden Versuche wurde Folgendes eingestellt:

Prozess: P$_{Hf}$ECVD-Beschichten
f$_{Hf}$: 27MHz
Substratdimension: 1,1 x 1,25m$^2$
Einformungstiefe d gemäss Fig. 6: 1mm
Totaldruck: 0,22mbar
Leistung pro Substratfläche: 280W/m$^2$
Substratmaterial: Floatglas, mit spezifischer
Leitfähigkeit: $10^{-15}$ $(\Omega m)^{-1}$
Voraufgebrachte Beschichtung: $InO_2$, dotiert mit Zinn.
Flächenwiderstand der Beschichtung R$_S$: $3\Omega_\square$
Reaktivgas: Silan unter Beimischung von $H_2$
Verdünnung Silan in $H_2$: 50%
Gesamter Gasfluss pro Flächeneinheit: 0,75slm/m$^2$

Die Versuche wurden an der Anlagenkonfigurationen gemäss Fig. 6 bzw. 7 gefahren.

In Figur 8, als Referenzresultat, ist die resultierende Schichtdickenverteilung in Nanometern bezüglich des Schichtdickenmittelwertes, über beide Rechteckdiagonalen des Werkstückes gemessen, dargestellt, wenn an der Anordnung gemäss Figur 6 die Platte 14 ohne Einformung 10 mit einer ebenen metallischen Fläche direkt als Elektrodenfläche der Elektrodenfläche EF$_1$ gegenüberliegend eingesetzt wird.

In Figur 9, weiterhin als Referenz, ist in analoger Darstellung wie in Figur 8, das Resultat aufgezeigt, wenn einerseits, als zu beschichtendes Werkstück, ein unbeschichtetes dielektrisches Substrat 100, gemäss Fig. 5, nämlich ein Floatglassubstrat, eingelegt ist.

Weiterhin ist, wie bereits für die Messung gemäss Fig. 8, die Platte 14 ohne Einformung 10 ausgebildet und bildet im Prozessraum PR eine der Elektroden. Hingegen ist eine der Einformung 10 entsprechende Einformung an der Grundfläche 3 unterhalb des Substrates vorgesehen.

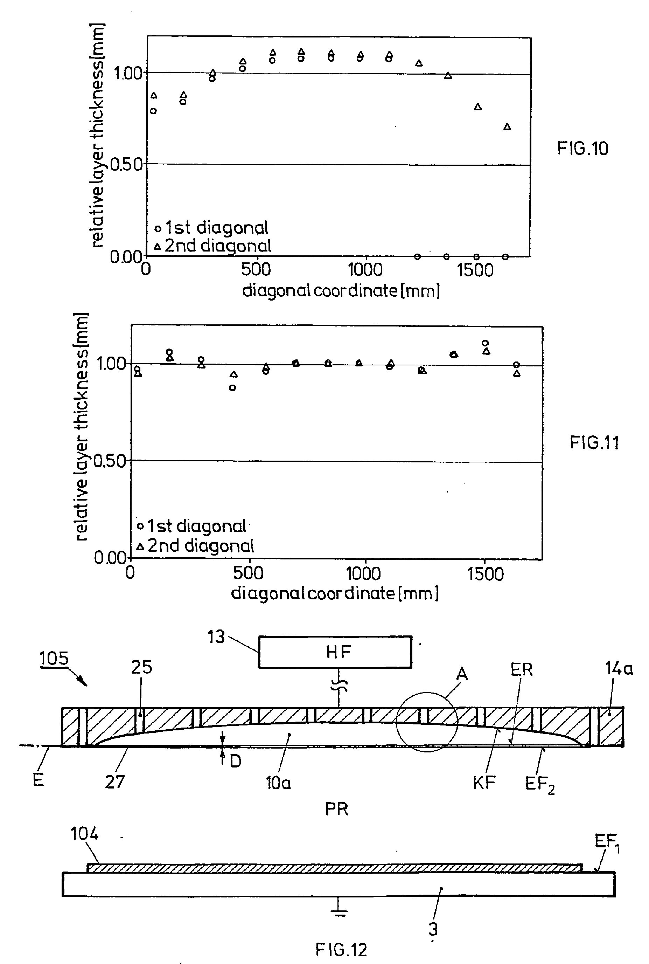

In weiterhin analoger Darstellung und weiter als Referenz zeigt Fig. 10 das Resultat, wenn an der Anlagenkonfiguration wie sie bereits für die Resultate gemäss Fig. 9 eingesetzt wurde, d.h. mit der Einformung 10 in der Grundfläche 3, abgedeckt durch das Substrat und Ausbildung der zweiten Elektrodenfläche durch die plane, dem Prozessraum PR ausgesetzte Oberfläche der Platt 14 das vorbeschichtete Substrat 104 behandelt wird, nämlich das mit $InO_2$ vorbeschichtete Floatgassubstrat.

Daraus ergibt sich folgendes:

- Aus Figur 8: Dass aufgrund der inhomogenen Feldverteilung im Prozessraum PR die resultierende Beschichtungsdickenverteilung inakzeptabel inhomogen ist.

- Aus Figur 9: Dass dann, wenn das zu behandelnde Substrat rein dielektrisch ist, die Einformung an der werkstücktragenden Elektrode (3) zu einer wesentlichen Verbesserung der Feldverteilung- und damit Schichtdickenverteilungs-Homogenität führt.

- Aus Figur 10: Dass die Anordnung, die für ein rein dielektrisches Werkstück gemäss Figur 9 zu einer wesentlichen Verbesserung der Schichtdickenverteilung führt, dann, wenn das Werkstück aus einem erfindungsgemäss vorbeschichteten Substrat 104 besteht, zu einer nicht akzeptablen Schichtdickenverteilung führt.

Wird nun aber das erwähnte vorbeschichtete Substrat z.B. mit der Anlage gemäss Fig. 6 beschichtet, resultiert die in Fig. 11 gezeigte gute Schichtdickenverteilung.

Es ist ersichtlich, dass erstaunlicherweise trotz dem hohen spezifischen Widerstand p des Schichtmaterials

(InO$_2$) sich ausschliesslich das vorgeschlagene Vorgehen zum Erzielen der homogenen Wirkungsverteilung am Werkstück eignet.

In Figur 12 ist, zusätzlich vereinfacht und schematisiert, eine weitere bevorzugte Ausführungsform des Behandlungsschrittes bzw. der hierfür eingesetzten Anlage 105 gemäss Fig. 5 dargestellt.

Das vorbeschichtete Substrat 104 ist wieder auf der planen ersten Elektrodenfläche EF$_1$ abgelegt. Die mit dem Hochfrequenzgenerator 13 verbundene metallische Kopplungsfläche KF ist bezüglich des Prozessraumes PR stetig konkav eingeformt.

Die dielektrische Plattenanordnung 27 bildet einerseits die plane dielektrische Elektrodenfläche EF$_2$ und, von konstanter Dicke, die ebenso plane Rückseite ER. In Fig. 12 ist das Öffnungsmuster durch die dielektrische Plattenanordnung 27 nicht dargestellt. Die dielektrische Plattenanordnung 27 weist eine Dicke D auf, für die bevorzugterweise gilt:

$$0{,}01 \text{ mm} \leq d \leq 5 \text{ mm}.$$

**Definition**

Unter dem Begriff dielektrische Plattenanordnung verstehen wir im Zusammenhang mit vorliegender Erfindung ein sich flächig zweidimensional erstreckendes, von folienartig bis plattenförmig sich präsentierendes, dielektrisches Gebilde.

Weil sich die Kapazität der dielektrischen Plattenanordnung 27 in Serie zu der Kapazität zwischen Kopplungsfläche KF und Rückseite ER der dielektrischen Platte präsentiert, vermag die bei dünner dielektrischer Plattenanordnung 27 sich ergebende, ggf. grosse Plattenkapazität die sich über die Kammer 10a ergebende kleine Kapazität nur unwesentlich zu beeinflussen.

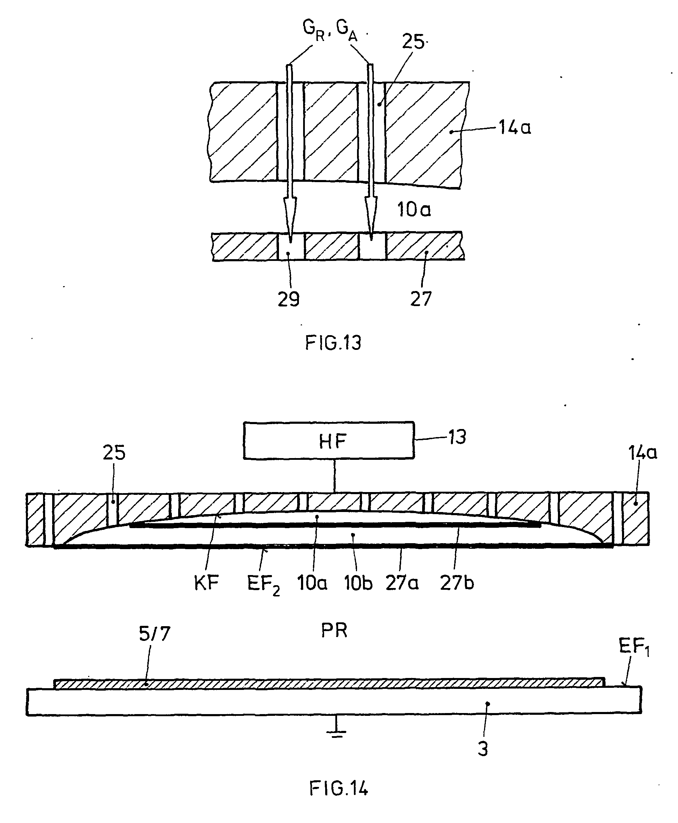

In Fig. 13 ist ein Ausschnitt der Anordnung gemäss Fig. 12, wie er bei A eingekreist ist, dargestellt. Daraus ist ersichtlich, dass mindestens ein Teil der Bohrungen 25 durch die Metallplatte 14a, sowohl bei der Ausführungsform gemäss Fig. 12 wie auch bei allen anderen Ausführungsformen, mit den Öffnungen 29 (nicht dargestellt) durch die dielektrische Plattenanordnung 27 fluchten kann und weiter mindestens genähert gleiche Öffnungsquerschnitte haben kann.

Obwohl die Kopplungsfläche KF in Fig. 12 stetig gekrümmt ist, ist es ohne weiteres möglich, sie in einer Stufe oder in mehreren Stufen geformt zu realisieren. Als Material der Plattenanordnung 27, welche einer hohen Temperaturbelastung ausgesetzt ist, einer aggressiven chemischen Atmosphäre, hohem Vakuum und dem Plasma kann, wie erwähnt wurde, eine Keramik, beispielsweise Al$_2$O$_3$ eingesetzt werden. Es können, je nach Prozess, gegebenenfalls auch andere dielektrische Materialien eingesetzt werden, bis hin zu Hochtemperatur-beständigen, dielektrischen Folien mit dem Öffnungsmuster. Die erwähnte dielektrische Plattenanordnung 27 kann ersetzt werden, wie in Fig. 14 dargestellt, durch mehrere, beabstandet übereinander liegende Plattenanordnungen 27a, 27b, welche durch dielektrische Abstandshalter gegenseitig positioniert werden. Alle diese Einzelplatten 27a, 27b weisen das Öffnungsmuster in Analogie zum Muster der Öffnungen 29 gemäss Fig. 6 bzw. 12 und 13 auf. Ihre Dicke kann wiederum zwischen 0,01 und 5 mm gewählt werden.

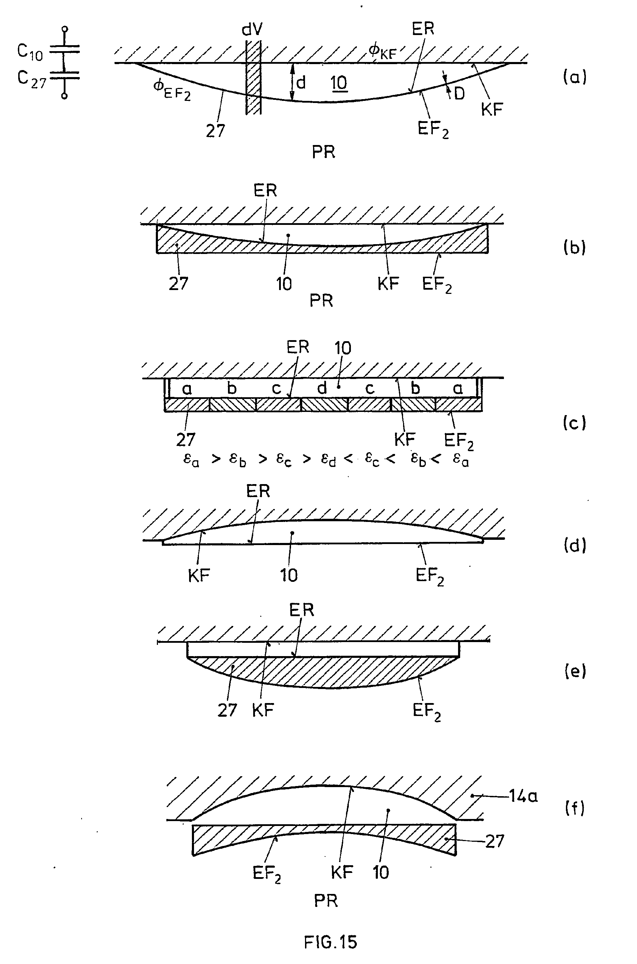

In Fig. 15(a) bis (f) sind mögliche gegenseitige Zuordnungen von metallischer Kopplungsfläche KF und dielektrischer Elektrodenfläche EF$_2$ schematisch dargestellt, welche alle dazu führen, dass im Prozessraum PR, im Peripheriebereich, das elektrische Feld, bezüglich des Feldes im Zentralbereich, verstärkt wird.

In Fig. 15(a) ist die metallische Kopplungsfläche KF plan. Die dielektrische Plattenanordnung 27 ist, bezüglich des Prozessraumes PR, konvex und von konstanter Dicke D. Aufgrund ihrer metallischen Eigenschaften wirkt die Kopplungsfläche KF bei Hochfrequenzpotentialbeaufschlagung als Äquipotentialfläche mit $\Phi_{KF}$. In erster Näherung kann die Anordnung gemäss Fig. 15(a) wie folgt betrachtet werden:

An jedem Volumenelement dV entlang der Kammer 10 ergibt sich die Serieschaltung einer Kapazität C$_{10}$ und C$_{27}$ wie links in der Fig. dargestellt. Während die Kapazität C$_{10}$ durch den variierenden Abstand zwischen Kopplungsfläche KF und Rückseite ER der dielektrischen Plattenanordnung 27 sowie die Dielektrizitätskonstante des Gases in der Kammer 10 bestimmt ist, ist die Kapazität C$_{27}$ örtlich konstant aufgrund der konstanten Dicke D und der Dielektrizitätskontanten E der Plattenanordnung 27.

Üblicherweise ist die Dielektrizitätskonstante des Plattenmaterials wesentlich grösser als diejenige des Gases in Kammer 10, womit insbesondere bei dünner Plattenanordnung 27 die Kapazität C$_{27}$, in der Serieschaltung mit C$_{10}$, mindestens in erster Näherung vernachlässigbar wird. Im Peripheriebereich der dielektrischen Elektrodenfläche EF$_2$ wird C$_{10}$ immer grösser, aufgrund des abnehmenden Abstandes d, womit sich lokal die Potentialverteilung $\Phi_{EF2}$ entlang der Elektrodenfläche EF$_2$ mit Annäherung an den Peripheriebereich dem Potential $\Phi_{KF}$ der Kopplungsfläche KF nähert.

Somit liegt über dem Prozessraum PR, im Peripheriebereich der Elektrodenfläche $EF_2$, die genähert ganze Potential-differenz zwischen $\Phi_{KF}$ und dem an der Gegenelektrodenfläche $EF_1$ angelegten Potential. Im Zentrumsbereich der Elektrodenfläche $EF_2$ ist $C_{10}$ aufgrund des grösseren Abstandes d kleiner als im Peripheriebereich, womit daran eine grössere Hochfrequenzspannung abfällt und damit dort das Potential $\Phi_{EF2}$ bezüglich des Potentials $\Phi_{KF}$ vermehrt abgesenkt ist. Somit liegt über dem Prozessraum PR in diesem Zentrumsbereich nurmehr ein bezüglich des Peripheriebereiches verringertes elektrisches Feld.

Aus der Betrachtung von Fig. 15(a) und unter Berücksichtigung, dass die Kammer 10 als Druckausgleichskammer für das aus dem Öffnungsmuster (nicht dargestellt) durch die dielektrische Plattenanordnung 27 dem Prozessraum PR zugespiesene Reaktivgas ist, ist ersichtlich, dass durch Einsatz einer folienartigen Hochtemperatur-beständigen Plattenanordnung 27 vorteilhafterweise die konvexe Formung aufgrund der Druckdifferenz zwischen Prozessraum und Kammer 10 erstellt werden kann.

In Fig. 15(b) ist die metallische Kopplungsfläche KF weiterhin plan. Die dielektrische Plattenanordnung 27 hat eine bezüglich dem Prozessraum PR konvexe geformte Rückseite ER, hingegen eine plane, zur Kopplungsfläche KF parallele Elektrodenfläche $EF_2$. Aufgrund der üblicherweise höheren Dielektrizitätskonstanten $\varepsilon$ des Materials der di-elektrischen Plattenanordnung 27 beeinflusst die Kapazität $C_{27}$ im Peripheriebereich die Kapazität $C_{10}$ (s. Fig. 15(a)), trotz erhöhter Dicke der Anordnung 27, dort nur unwesentlich, so dass auch bei der Ausführungsform gemäss Fig. 15 (b) die örtlich variierende Kapazität $C_{10}$ in Serieschaltung dominiert und wie erläutert wurde die Feldverteilung im Prozessraum PR dominierend beeinflusst.

Bei der Ausführungsform gemäss Fig. 15(c) ist die Kopplungsfläche KF weiterhin plan. Die dielektrische Plattenanordnung 27 hat eine konstante Dicke, hingegen wird sie gebildet durch abschnittsweise unterschiedliche Materialien unterschiedlicher Dielektrizitätskonstanten $\varepsilon a$ bis $\varepsilon d$. Hier kann die Kammer 10 entfallen,

Gegen die Peripherie hin nimmt die Dielektrizitätskonstante E des Plattenmaterials zu, womit mit Blick auf das Ersatzbild in Fig. 15(a) $C_{27}$ zunimmt. Bei dieser Ausführungsform ist die durch die Kammer 10 gebildete Kapazität $C_{10}$ lokal konstant. Wird hier die konstante Dicke der dielektrischen Plattenanordnung 27 genügend gross gewählt, so wird die gegen den Peripheriebereich hin grösser werdende Kapazität $C_{27}$ in Serieschaltung mit $C_{10}$ dominierend und es wird der bereits beschriebene Effekt erzielt: Im Randbereich der Elektrodenfläche $EF_2$ wird das elektrische Feld im Prozessraum PR weniger abgeschwächt als im zentralen Bereich, wo $C_{27}$ mit $\varepsilon_d$ bezüglich $C_{27}$ mit $\varepsilon_a$ verringert ist.

Fig. 15(d) zeigt die bereits erläuterten Verhältnisse gemäss Fig. 6 bzw. Fig. 12.

Fig. 15(e) zeigt eine plane Kopplungsfläche KF. Die dielektrische Platte 27 hat eine plane, zur Kopplungsfläche KF parallele Rückseite E, hingegen eine vom Prozessraum PR her betrachtete konvexe dielektrische Elektrodenfläche $EF_2$. Aus den bisherigen Erläuterungen entnimmt der Fachmann ohne weiteres, dass damit derselbe Feldkompensationseffekt im Prozessraum PR erzielt werden kann, wie er bisher erläutert wurde, nach Massgabe der gewählten Plattendicke und Plattenmaterial-Dielektrizitätskonstanten.

In Fig. 15(f) ist sowohl die Kopplungsfläche KF wie auch die Elektrodenfläche $EF_2$ bezüglich des Prozessraumes PR konkav, die Rückseite ER der Plattenanordnung 27 hingegen plan.

Ist die Dielektrizitätskontante der Plattenanordnung 27 wesentlich grösser als diejenige des Gases in Kammer 10, so dominiert auch hier $C_{10}$ und ergibt die erwünschte Feldverteilung im Prozessraum PR.

Aus den Fig. 15(a) bis (f) ist ersichtlich, dass insbesondere bezüglich der Form der dielektrischen Elektroden-fläche $EF_2$ hohe Flexibilität besteht. Die in Fig. 15 dargestellten Varianten können, wie der Fachmann ohne weiteres erkennt, erweitert und kombiniert werden, wie beispielsweise Vorsehen unterschiedlicher Materialen an der Plattenanordnung 27 kombiniert mit variierender Dicke etc., was den Auslegungsspielraum noch weiter erhöht. Wie bereits erwähnt wurde, kann die Kammer 10 entfallen und die Kapazitätsverteilung ausschliesslich durch die Plattenanordnung 27 realisiert werden.

Bedenkt man, dass das Reaktivgas aus der Kammer 10 durch das an der Plattenanordnung 27 vorgesehene Öffnungsmuster in den Prozessraum eingelassen wird und weiter, dass die erwünschten Feldkompensations-Massnahmen weitgehend unabhängig von der Form der Elektrodenfläche $EF_2$ realisiert werden können, so wird ersichtlich, dass gleichzeitig Gasausdüsungsrichtung in den Prozessraum PR sowie Feldbeeinflussung im Prozessraum PR je optimiert werden können.

Bei der Realisierung der dielektrischen Plattenanordnung 27 ist zu berücksichtigen, dass diese während dem Behandlungsprozess insbesondere hohen Temperaturen ausgesetzt wird. Damit sind thermische Ausdehnungsdifferenzen zwischen dielektrischer Plattenanordnung 27 und, über ihre Fixation, der die Kopplungsfläche KF bildenden Platte 14 zu berücksichtigen. Im Weiteren muss bedacht werden, dass mit der beschriebenen Anlage grosse, ja sehr grosse Substrate 104 behandelt werden sollen. Die Realisation einer dielektrischen Plattenanordnung dieses Ausmasses sowie ihre Montage, so dass jedenfalls thermische Ausdehnungen und Kontraktionen ohne Verformungen aufgenommen werden können, stellt insbesondere dann Probleme, wenn die Anordnung 27 nicht folienartig ist, sondern als starre dielektrische Platte, beispielsweise aus einer Keramik, wie aus $Al_2O_3$ besteht.

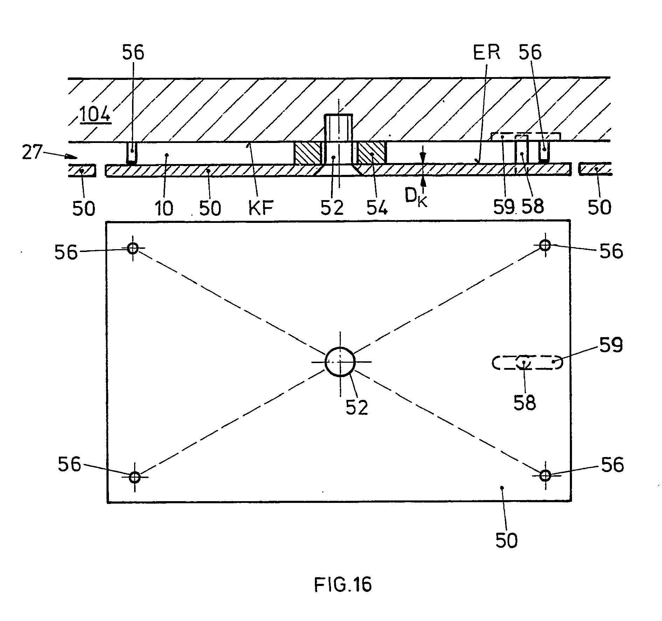

Erfindungsgemäß wird die feste Anordnung 27, wie anhand von Fig. 16 erläutert werden soll, durch eine Vielzahl dielektrischer, bevorzugterweise keramischer Kacheln, zusammengesetzt. In Fig. 16 ist in Aufsicht und in Querschnittsdarstellung eine solche Kachel und ihre Montage dargestellt. Die jeweilige Kachel 50, wie dargestellt bevorzugt rechteck- oder quadratförmig und aus einem Keramikmaterial wie beispielsweise $Al_2O_3$ gefertigt, ist im wesentlichen zentral mittels eines dielektrischen Abstandsbolzens 52, wie beispielsweise einer Keramikschraube, sowie mittels einer dielektrischen Unterlegscheiben 54 bezüglich der Kopplungsfläche KF an der Platte 104 positioniert. Dadurch wird der relevante Abstand zwischen Fläche KF und Rückseite ER der die Plattenanordnung 27 bildenden Kacheln 50 sichergestellt. Damit die Kacheln 50 peripher abgestützt sind und sich trotzdem bei thermischer Belastung ohne Spannung allseits frei ausdehnen können, sind sie auf Abstützstiften 56 bezüglich der Kopplungsfläche KF geführt. Gegen Verdrehen sind die Kacheln 50 mittels eines Führungsstiftes 58 in einer Langlochführung 59 gesichert. Die Kacheln 50 werden mit dem in Fig. 16 nicht dargestellten Öffnungsmuster versehen, das ggf. ergänzt wird durch Spalten zwischen den Kacheln 50. Die Kacheln 50 können sich ggf. auch überlappen. Es können ein oder mehrere Lagen solcher Kacheln vorgesehen werden, ggf. örtlich variierend, und es können in verschiedenen Bereichen unterschiedliche Keramikmaterialien, insbesondere mit unterschiedlichen Dielektrizitätskonstanten eingesetzt werden. Damit können flexibel unterschiedliche Formungen und Materialprofile an der dielektrischen Plattenanordnung 27 realisiert werden.

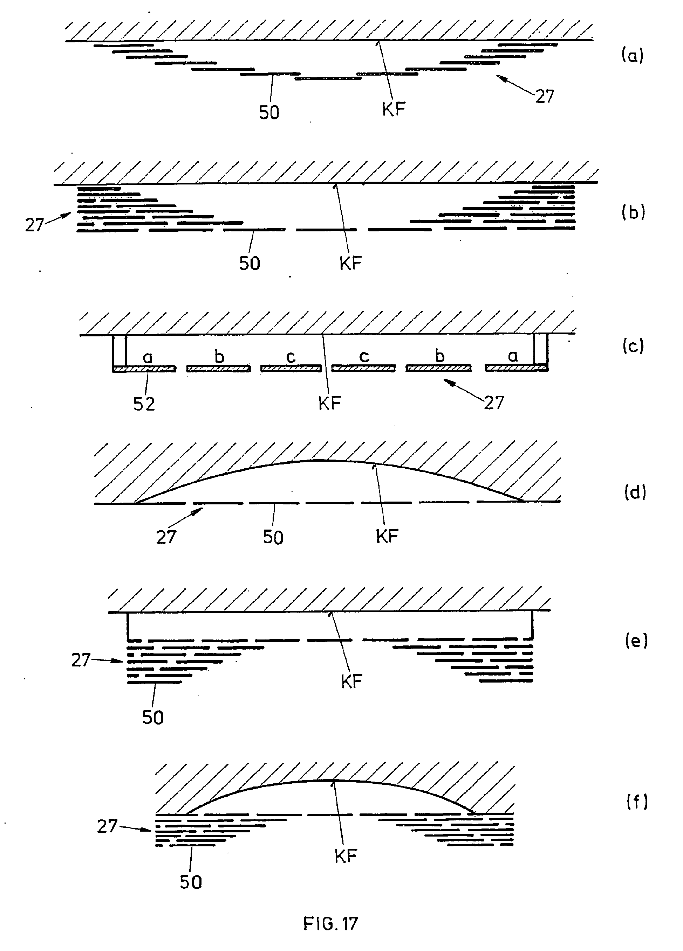

In Fig. 17(a) bis (f) sind schematisch die Konfigurationen gemäss Fig. 15(a) bis (f) dargestellt, aufgebaut mittels Kacheln bevorzugt wie anhand von Fig. 16 erläutert. Dabei müssen lediglich die der Kopplungsfläche KF unmittelbar gegenüberliegenden Kacheln gemäss Fig. 17 abgestützt werden, prozessraumseitig anschliessende Kachellagen werden an den darunter liegenden Kacheln montiert. Aus Betrachtung von Fig. 17(a) bis (f) versteht der Fachmann ohne weiteres, wie in der erwähnten bevorzugten Kachelbauweise die Konfigurationen gemäss den Fig. 15(a) bis (f) aufgebaut werden. Dabei muss, im Sinne des vorerwähnten Öffnungsmusters, eine in erwünschtem Masse verteilte Gaseindüsung in den Prozessraum sichergestellt werden, sei dies durch Ausnützung zwischen den Kacheln verbleibender Labyrinthkanäle und/oder Vorsehen zusätzlicher Bohrungen bzw. Öffnungen durch die Kacheln 50 (nicht dargestellt).

Bevorzugterweise wird die Dicke keramischer Kachel $D_K$ zu

$$0{,}1 \text{ mm} \leq D_K \leq 2 \text{ mm}$$

gewählt.

Mit dem erfindungsgemässen Herstellungsverfahren, das mittels der erfindungsgemässen Anlage durchgeführt wird, lassen sich homogen grosse, ja sehr grosse dielektrische Substrate erst mit speziellen leitenden Schichten beschichten, dann durch reaktive, hochfrequenzplasmaunterstützte Verfahren oberflächenbehandeln, insbesondere beschichten, wodurch insbesondere grosse bis sehr grosse Solarzellen grossindustriell gefertigt werden können.

**Patentansprüche**

1. Vakuumbehandlungsanlage mit

   ● einem Vakuumrezipienten (105a), darin einer ersten planen metallischen Elektrodenfläche ($EF_1$),
   ● einer zweiten, der ersten zugewandten dielektrischen Elektrodenfläche ($EF_2$), die eine Oberfläche einer dielektrischen flächigen Anordnung (27) bildet,
   ● einer der Rückseite (ER) der flächigen Anordnung (27) zugewandte, metallische Kopplungsfläche (KF),
   ● elektrische Anschlüsse je an die Kopplungs- (KF) und an die erste Elektrodenfläche ($EF_1$),
   ● ein Gasleitungssystem (17), durch die Kopplungsfläche (KF) und ein flächig verteiltes Muster von Öffnungen (29) durch die flächige Anordnung (27),

   **dadurch gekennzeichnet, dass** die flächige dielektrische Anordnung (27) durch mehrere keramische Kacheln (50) gebildet ist, die zentral bezüglich der Kopplungsfläche auf Abstand positioniert montiert sind.

2. Anlage nach Anspruch 1, **dadurch gekennzeichnet, dass** mindestens ein Teil der Kacheln (50) an der metallischen Kopplungsfläche (KF) durch mindestens genähert im Kachelzentrum angeordnete, dielektrische Stützen (52) gehaltert wird.

3. Anlage nach einem der Ansprüche 1 oder 2, **dadurch gekennzeichnet, dass** die Kacheln (50) die dielektrische Elektrodenfläche ($EF_2$) plan oder von der ersten Elektrodenfläche her betrachtet konvex oder konkav aufspannen.

4. Anlage nach einem der Ansprüche 1 bis 3, **dadurch gekennzeichnet, dass** die Kopplungsfläche (KF) von der ersten ($EF_1$) Elektrodenfläche her betrachtet gestuft oder stetig konkav geformt ist.

**5.** Anlage nach einem der Ansprüche 1 bis 4, **dadurch gekennzeichnet, dass** an der metallischen Kopplungsfläche (KF) Gaseinlassöffnungen vorhanden sind, deren überwiegende Anzahl mit Öffnungen (29) des Musters fluchten und vorzugsweise gleiche Öffnungsquerschnitte haben.

**6.** Anlage nach einem der Ansprüche 1 bis 5, **dadurch gekennzeichnet, dass** mindestens ein Teil der Kacheln (50) durch mindestens einen Führungsstift (58) in Langlochführung (59) gegen Verdrehung gesichert ist.

**7.** Anlage nach einem der Ansprüche 1 bis 6, **dadurch gekennzeichnet, dass** mindestens ein Teil der Kacheln (50) durch Abstandsstifte (56) bezüglich der Kopplungsfläche und relativ zur Kopplungsfläche, in ihren Flächenausdehnungs-Richtungen frei beweglich, abgestützt sind.

**8.** Verfahren zur Herstellung eines scheibenförmigen Werkstückes auf der Basis eines dielektrischen Substrates (100), welches mindestens abschnittsweise mit einem Schichtmaterial beschichtet ist, für dessen spezifischen Widerstand p gilt

$$10^{-5} \ \Omega cm \ \le \rho \le 10^{-1} \ \Omega cm$$

und für den Flächenwiderstand $R_S$ der Schicht gilt:

$$0 \ < \ R_S \le 10^4 \ \Omega_{\square},$$

wobei das Schichtmaterial anschliessend in einem Plasmaprozessraum (PR) **der** Vakuumbehandlungsanlage **gemäss** einem **der Ansprüche** 1 **bis** 7 reaktiv plasmaunterstützt geätzt oder beschichtet wird, indem zwischen zwei sich gegenüberliegenden Elektrodenflächen (2a; $EF_1$, 2b; $EF_2$) in einem Vakuumrezipienten ein elektrisches Hochfrequenzfeld erzeugt wird und damit in dem mit einem Reaktivgas beschickten Prozessraum (PR) eine HochfrequenzPlasmaentladung erstellt wird, dabei die eine Elektrodenfläche (2b, $EF_2$) aus dielektrischem Material ist, an diese ein Hochfrequenzpotential ($\Omega_{2b}$) mit entlang der Fläche vorgegebener, variierender Verteilung angelegt wird und die Verteilung des elektrischen Feldes im Plasmaprozessraum (PR) durch die Potentialverteilung ($\Phi_{2b}$) an der dielektrischen Elektrodenfläche (2b, $EF_2$) eingestellt wird und dabei das Substrat an der metallisch ausgebildeten anderen (2a, $EF_1$) Elektrodenfläche angeordnet wird und weiter an der dem Substrat gegenüberliegenden Elektrodenfläche aus einem Öffnungsmuster (29) das Reaktivgas in den Prozessraum (PR) eingelassen wird.

**9.** Verfahren nach Anspruch 8, **dadurch gekennzeichnet, dass** das dielektrische Substrat (100) erst mit einem elektrisch leitenden Oxid beschichtet wird und dann (104) der Behandlung im Plasmaprozessraum unterzogen wird.

**10.** Verfahren nach Anspruch 9, **dadurch gekennzeichnet, dass** als leitendes Oxid ein transparentes gewählt wird.

**11.** Verfahren nach Anspruch 8, **dadurch gekennzeichnet, dass** das dielektrische Substrat (100) mit mindestens einem der Materialien ZnO, $InO_2$, $SnO_2$, dotiert oder nicht dotiert, beschichtet und danach der Behandlung im Plasmaprozessraum (PR) unterzogen wird.

**12.** Verfahren nach einem der **Ansprüche** 8 **bis** 11, **dadurch gekennzeichnet, dass** das dielektrische Substrat vor der Behandlung im Plasmaprozessraum mit einer Schicht des Schichtmaterials beschichtet wird, für deren Dicke $D_S$ gilt:

$$10 \ nm \ \le \ D_S \ \le \ 5 \ \mu m.$$

**13.** Verfahren nach einem der **Ansprüche** 8 **bis** 12, **dadurch gekennzeichnet, dass** das Reaktivgas mindestens eines der Gase $NH_3$, $N_2$, $SF_6$, $CF_4$, $Cl_2$, $O_2$, $F_2$, $CH_4$, Silan, Disilan, $H_2$, Phosphin, Diboran, Trimetlybor, $NF_3$ enthält.

**14.** Verfahren nach einem der **Ansprüche** 8 **bis** 13, **dadurch gekennzeichnet, dass** das Hochfrequenzfeld mit einer Frequenz $f_{Hf}$ angeregt wird für die gilt:

$$10\ \text{MHz} \le f_{Hf} \le 500\text{MHz}$$

insbesondere

$$13\ \text{MHz} \le f_{Hf} \le 70\ \text{MHz}.$$

**15.** Verfahren nach einem der **Ansprüche** 8 **bis** 14, **dadurch gekennzeichnet, dass** der Umkreisdurchmesser des Substrates mindestens 0,5m ist.

**Claims**

**1.** Vacuum treatment installation having

- a vacuum recipient (105a), therein a first planar metallic electrode surface ($EF_1$),
- a second dielectric electrode surface ($EF_2$) facing the first, which forms a surface of an areal dielectric arrangement (27),
- a metallic coupling surface (KF) facing the back side (ER) of the areal arrangement (27),
- electrical connections each on the coupling surface (KF) and on the first electrode surface ($EF_1$),
- a gas delivery system (17) through the coupling surface (KF) and an areally distributed pattern of openings (29) through the areal arrangement (27),

**characterised in that** the areal dielectric arrangement (27) is formed by a plurality of ceramic tiles (50) which are mounted centrally with respect to the coupling surface, positioned at a distance.

**2.** Installation according to claim 1, **characterised in that** at least a portion of the tiles (50) are held by dielectric supports (52) arranged at least approximately in the centre of the tile on the metallic coupling surface (KF).

**3.** Installation according to one of claims 1 or 2, **characterised in that** the tiles (50) span the dielectric electrode surface ($EF_2$) in a flat or convex or concave manner, considered from the first electrode surface.

**4.** Installation according to one of claims 1 to 3, **characterised in that** the coupling surface (KF) is formed stepped or continuously concave considered from the first ($EF_1$) electrode surface.

**5.** Installation according to one of claims 1 to 4, **characterised in that** gas inlet openings are present on the metallic coupling surface (KF), the preponderance of whose number align with openings (29) of the pattern and preferably have the same opening diameter.

**6.** Installation according to one of claims 1 to 5, **characterised in that** at least a portion of the tiles (50) are secured against rotation by at least one guide pin (58) in a long hole guide (59).

**7.** Installation according to one of claims 1 to 6, **characterised in that** at least a portion of the tiles (50) are supported by distance pins (56) with respect to the coupling surface and relative to the coupling surface, freely movable in the directions of the extent of their plane.

**8.** Method for manufacturing a disc-shaped workpiece on the basis of a dielectric substrate (100), at least a part thereof being coated with a coating material for whose resistivity ρ is valid

$$10^{-5}\ \Omega\text{cm} \le \rho \le 10^{-1}\ \Omega\text{cm}$$

and for the surface resistance $R_S$ of the coating is valid:

$$0 < R_s \le 10^4\ \Omega_{\square},$$

whereby the coating material is subsequently plasma-enhanced reactive etched or coated in a plasma process space (PR) of the vacuum treatment installation according to one of claims 1 to 7, in which a high-frequency electric field is generated between two mutually-opposing electrode surfaces (2a; $EF_1$, 2b; $EF_2$) in a vacuum recipient, and therewith a high-frequency plasma discharge is generated in the process space (PR) which is fed with a reactive gas, whereby the one electrode surface (2b, $EF_2$) is of dielectric material, to this is applied a high-frequency potential ($\Omega_{2b}$) with a predetermined, varying distribution along the surface, and the distribution of the electrical field in the plasma process space (PR) is adjusted by the potential distribution ($\Omega_{2b}$) on the dielectric electrode surface (2b, $EF_2$), and whereby the substrate is arranged on the metallically-constructed other (2a, $EF_1$) electrode surface, and furthermore the reactive gas is inlet into the process space (PR) out of a pattern of openings (29) on the electrode surface opposite the substrate.

9. Method according to claim 8, **characterised in that** the dielectric substrate (100) is first coated with an electrically-conductive oxide and is then (104) subjected to the treatment in the plasma process space.

10. Method according to claim 9, **characterised in that** a transparent oxide is chosen as the conductive oxide.

11. Method according to claim 8, **characterised in that** the dielectric substrate (100) is coated with at least one of the materials ZnO, $InO_2$, $SnO_2$, doped or undoped, and is subsequently subjected to the treatment in the plasma process space (PR).

12. Method according to one of claims 8 to 11, **characterised in that** the dielectric substrate is coated with a layer of the coating material before treatment in the plasma process space, for the thickness $D_S$ of which applies:

$$10nm \leq D_s \leq 5\mu m.$$

13. Method according to one of claims 8 to 12, **characterised in that** the reactive gas contains at least one of the gases $NH_3$, $N_2$, $SF_6$, $CF_4$, $Cl_2$,$O_2$, $F_2$, $CH_4$, Silane, Disilane, $H_2$, Phosphine, Diborane, Trimethylboron, $NF_3$.

14. Method according to one of claims 8 to 13, **characterised in that** the high-frequency field is excited with a frequency $f_{Hf}$ for which applies:

$$10\ MHz \leq f_{Hf} \leq 500\ MHz$$

particularly

$$13\ MHz \leq f_{Hf} \leq 70\ MHz.$$

15. Method according to one of claims 8 to 14, **characterised in that** the peripheral diameter of the substrate is at least 0.5 m.

**Revendications**

1. Installation de traitement sous vide ayant

- un récipient sous vide (105a), une première surface électrode métallique planaire ($EF_1$) là-dedans,
- une seconde surface électrode diélectrique ($EF_2$) en face de la première, qui forme une surface d'un agencement diélectrique étendu (27),
- une surface métallique d'accouplement (KF) en face du côté arrière (ER) de l'agencement étendue (27),
- des connexions électriques sur chacune, la surface d'accouplement (KF) et sur la première surface d'électrode ($EF_1$),
- un système d'approvisionnement de gaz (17) à travers la surface d'accouplement (KF) et un motif distribué étendu d'ouvertures (29) à travers l'agencement étendu (27),

**caractérisé en ce que** l'agencement diélectrique étendu (27) est formé par une pluralité de carreaux céramiques (50) montés centralement et à distance par rapport à la surface d'accouplement.

2. Installation selon la revendication 1, **caractérisé en ce qu'**au moins une partie des carreaux (50) sont tenues par des supports diélectriques (52) agencés au moins approximativement au centre du carreau sur le surface métallique d'accouplement (KF).

3. Installation selon l'une des revendications 1 ou 2, **caractérisé en ce que** les carreaux (50) définissent la surface d'électrode diélectrique (EF$_2$) plane ou convexe ou concave, considéré à partir de la première surface d'électrode.

4. Installation selon l'une des revendications 1 à 3, **caractérisé en ce que** la surface d'accouplement (KF) est formée échelonnée ou continuellement concave, considéré à partir de la première (EF$_1$) surface d'électrode.

5. Installation selon l'une des revendications 1 à 4, **caractérisé en ce que** des ouvertures d'entrée de gaz sont disponibles sur la surface métallique d'accouplement (KF), dont le nombre prédominant s'alignent avec des ouvertures (29) du motif et présentent de préférence le même diamètre d'ouverture.

6. Installation selon l'une des revendications 1 à 5, **caractérisé en ce qu'**au moins une partie des carreaux (50) sont assurés contre rotation par moyens d'au moins une goupille de guidage (58) dans un trou allongé de guidage (59).

7. Installation selon l'une des revendications 1 à 6, **caractérisé en ce qu'**au moins une partie des carreaux (50) sont supportés par des goupilles d'écartement (56) par rapport à la surface d'accouplement et relatif à la surface d'accouplement, libres en déplacement dans des directions dans l'étendue de leur plan.

8. Procédé de manufacture d'une pièce en forme de disque basée sur un substrat diélectrique (100), au moins une partie dont est revêtue avec un matériau de revêtement auquel la résistivité spécifique s'applique:

$$10^{-5} \ \Omega\mathrm{cm} \ \leq \ \rho \ \leq \ 10^{-1} \ \Omega\mathrm{cm}$$

et pour la résistance de surface du revêtement R$_S$ s'applique:

$$0 \ < \ \mathrm{R_s} \ \leq 10^4 \ \Omega_\square,$$

dans lequel le matériau de revêtement est ensuite gravé ou revêtu de manière réactive dans un espace de traitement sous plasma (PR) de l'installation de traitement sous vide selon l'une des revendications 1 à 7, dans lequel un champ électrique d'haute fréquence est généré entre deux surfaces électrode mutuellement opposées (2a ; EF$_1$, 2b ; EF$_2$) dans un récipient sous vide, et, y accompagnant, une décharge de plasma d'haute fréquence est générée dans l'espace de traitement (PR) qui est alimenté avec un gaz réactif, dans lequel l'une surface électrode (2b, EF$_2$) est d'un matériau diélectrique, à laquelle est appliqué un potentiel d'haute fréquence ($\Omega_{2b}$) ayant une distribution prédéterminée variante le long de la surface, et la distribution du champ électrique dans l'espace de traitement plasma (PR) est ajustée par la distribution de potentiel ($\Omega_{2b}$) sur la surface d'électrode diélectrique (2b, EF$_2$), et dans laquelle le substrat est agencé sur l'autre (2a, EF$_1$) surface d'électrode de construction métallique, et en outre, le gaz réactif est introduit dans l'espace de traitement (PR) en sortant d'un motif d'ouvertures (29) sur la surface d'électrode opposée au substrat.

9. Procédé selon la revendication 8, **caractérisé en ce que** le substrat diélectrique (100) est d'abord revêtu avec un oxyde conducteur d'électricité et puis (104) est soumis au traitement dans l'espace de traitement plasma.

10. Procédé selon la revendication 9, **caractérisé en ce qu'**un oxyde transparent est choisi comme oxyde conducteur d'électricité.

11. Procédé selon la revendication 8, **caractérisé en ce que** le substrat diélectrique (100) est revêtu avec au moins l'un des matériaux ZnO, InO$_2$, SnO$_2$, doté ou non-doté, et subséquemment est soumis au traitement dans l'espace de traitement plasma (PR).

**12.** Procédé selon l'une des revendications 8 à 11, **caractérisé en ce que** le substrat diélectrique est revêtu avec une couche du matériau de revêtement avant le traitement dans l'espace de traitement plasma, dont s'applique pour l'épaisseur $D_S$ :

$$10nm \leq D_s \leq 5\mu m.$$

**13.** Procédé selon l'une des revendications 8 à 12, **caractérisé en ce que** le gaz réactif contient au moins l'un des gazes $NH_3$, $N_2$, $SF_6$, $CF_4$, $Cl_2$, $O_2$, $F_2$, $CH_4$, Silane, Disilane, $H_2$, Phosphine, Diborane, Triméthylbore, $NF_3$.

**14.** Procédé selon l'une des revendications 8 à 13, **caractérisé en ce que** le champ d'haute fréquence est excité avec une fréquence $f_{Hf}$ pour laquelle s'applique :

$$10 \text{ MHz} \leq f_{Hf} \leq 500 \text{ MHz}$$

particulièrement

$$13 \text{ MHz} \leq f_{Hf} \leq 70 \text{ MHz}.$$

**15.** Procédé selon l'une des revendications 8 à 14, **caractérisé en ce que** le diamètre périphérique du substrat est au moins 0.5m.

FIG.1

FIG.2

FIG.3

PR

FIG.4

FIG.5

FIG.6

FIG.7

FIG.8

FIG.9

FIG.10

FIG.11

FIG.12

$G_R, G_A$   25

14a

10a

29   27

FIG.13

HF — 13

25   14a

KF   EF₂   10a   10b   27a   27b

PR

5/7   EF₁

3

FIG.14

FIG.15

56    ER  56

104

27

50    10  50   KF   52   54   $D_K$   59 58   50

56    56

59

52    58

50

FIG.16

(a)

(b)

(c)

(d)

(e)

(f)

FIG. 17

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6228438 B1
- EP 0382632 A
- US 6631692 B
- US 20030089314 A
- US 6228438 B